Europäisches Patentamt

European Patent Office

Office européen des brevets

(19)

(11) Publication number: **0 051 980**
**A1**

# (12) EUROPEAN PATENT APPLICATION

(21) Application number: **81305248.7**

(22) Date of filing: **04.11.81**

(51) Int. Cl.³: **H 01 L 31/06, H 01 G 9/20**

(30) Priority: **10.11.80 US 205529**

(43) Date of publication of application: **19.05.82**
**Bulletin 82/20**

(84) Designated Contracting States: **DE FR GB IT NL**

(71) Applicant: **ATLANTIC RICHFIELD COMPANY, 515 South Flowers Street, Los Angeles California 90071 (US)**

(72) Inventor: **Madan, Arun, 31520 Evergreen Road, Birmingham Michigan 48009 (US)**
Inventor: **Ovshinsky, Stanford Robert, 2700 Squirrel Road, Bloomfield Hills Michigan 48013 (US)**

(74) Representative: **Coleman, Stanley et al, MATHYS & SQUIRE 10 Fleet Street, London EC4Y 1AY (GB)**

(54) **Photovoltaic device and photoelectrochemical cell electrode.**

(57) Open circuit voltage enhancement of photovoltaic devices (10) and electrophotochemical cell electrodes (74) is made possible by adding a thin insulating layer (16, 80) to the semiconductor bodies (13, 76) of the devices. The insulating layer may be added between semiconductor layers of different conductivity within the active photoresponsive regions of the bodies. The bodies may be formed from an amorphous silicon alloy containing fluorine, and preferably hydrogen. The fluorine acts as a compensating or altering element to reduce the density of states in the energy gap thereof. The semiconductor bodies may be also formed from crystalline or polycrystalline semiconductor materials as well. Also disclosed is an electrode for use in an electrophotochemical cell, which electrode includes an insulating layer (80) over the semiconductor electrode body (76) in accordance with the present invention. The insulating layer enhances the open circuit voltage of the devices without affecting short circuit current to increase the efficiency of the devices.

## PHOTOVOLTAIC DEVICE & PHOTOELECTROCHEMICAL CELL ELECTRODE

This invention relates to enhanced photovoltaic devices and photochemical cell electrodes. The invention has its most important application in making improved photovoltaic devices for specific photoresponsive applications including photoreceptive devices such as solar cells of a p-i-n, p-n, Schottky or MIS (metal-insulator-semiconductor) type and electrochemical cells.

Silicon is the basis of the huge crystalline semiconductor industry and is the material which has produced expensive high efficiency (18 per cent) extrinsic crystalline solar cells. When crystalline semiconductor technology reached a commercial state, it became the foundation of the present huge semiconductor device manufacturing industry. This was due to the ability of the scientist to grow substantially defect-free germanium and particularly silicon crystals, and then turn them into extrinsic materials with p-type and n-type conductivity regions therein. This was accomplished by diffusing into such crystalline material parts per million of donor (n) or acceptor (p) dopant materials introduced as substitutional impurities into the substantially pure crystalline materials, to increase their electrical conductivity and to control their being either of a p or n conduction type. The fabrication processes for making p-n junction crystals involve extremely complex, time consuming, and expensive procedures. Thus, these crystalline materials useful in solar cells and current control devices are produced under very carefully controlled conditions by growing individual single silicon or germanium crystals, and when p-n junctions are required, by doping such single crystals with extremely small and critical amounts of dopants.

These crystal growing processes produce such relatively small crystals that solar cells require the assembly of many single crystals to encompass the desired area of only a single solar cell panel. The amount of energy necessary to make a solar cell in this process, the limitation caused by the size limitations of the silicon crystal, and the necessity to cut up and assemble such a crystalline material have all resulted in an impossible economic barrier to the large scale use of crystalline semiconductor solar cells for energy conversion. Further, crystalline silicon has an indirect optical edge which results in poor light absorption in the material. Because of the poor light absorption, crystalline solar cells have to be at least 50 microns thick to absorb the incident sunlight. Even if the single crystal material is replaced by polycrystalline silicon with cheaper production processes, the indirect optical edge is still maintained; hence the material thickness is not reduced. ·The polycrystalline material also involves the addition of grain boundaries and other problem defects.

In summary, crystal silicon devices have fixed parameters which are not variable as desired, require large amounts of material, are only producible in relatively small areas and are expensive and time consuming to produce. Devices manufactured with amorphous silicon can eliminate these crystal silicon disadvantages. Amorphous silicon has an optical absorption edge having properties similar to a direct gap semiconductor and only a material thickness of one micron or less is necessary to absorb the same amount of sunlight as the 50 micron thick crystalline silicon. Further, amorphous silicon can be made faster, easier and in larger areas than can crystal silicon.

Accordingly, a considerable effort has been made to develop processes for readily depositing amorphous semiconductor alloys or films, each of which can encompass relatively large areas, if desired, limited only by the size of the deposition equipment, and which could be readily doped to form p-type and n-type materials where p-n junction devices are to be made therefrom equivalent to those produced by their crystalline counterparts. For many years such work was substantially unproductive. Amorphous silicon or germanium (Group IV) films are normally four-fold coordinated and were found to have microvoids and dangling bonds and other defects which produce a high density of localized states in the energy gap of amorphous silicon semiconductor films, results in a low degree of photoconductivity and short carrier lifetime, making such films unsuitable for photo-responsive applications. Additionally, such films cannot be successfully doped or otherwise modified to shift the Fermi level close to the conduction or valence bands, making them unsuitable for making p-n junctions for solar cell and current control device applications.

In an attempt to minimize the aforementioned problems involved with amorphous silicon and germanium, W.E. Spear and P.G. Le Comber of Carnegie Laboratory of Physics, University of Dundee, in Dundee, Scotland, did some work on "Substitutional Doping of Amorphous Silicon", as reported in a paper published in Solid State Communications, Vol. 17, pp. 1193-1196, 1975, toward the end of reducing the localized states in the energy gap in amorphous silicon or germanium to make the same approximate more closely intrinsic crystalline silicon or germanium and of substitutionally doping the amorphous materials with suitable classic dopants, as in doping crystalline materials, to make them extrinsic and of p or n conduction types.

The reduction of the localized states was accomplished by glow discharge deposition of amorphous silicon films wherein a gas of silane ($SiH_4$) was passed through a reaction tube where the gas was decomposed by an r.f. glow discharge and deposited on a substrate at a substrate temperature of about 500-600°K (227-327°C). The material so deposited on the substrate was an intrinsic amorphous material consisting of silicon and hydrogen. To produce a doped amorphous material a gas of phosphine ($PH_3$) for n-type conduction or a gas of diborane ($B_2H_6$) for p-type conduction were premixed with the silane gas and passed through the glow discharge reaction tube under the same operating conditions. The gaseous concentration of the dopants used was between about $5 \times 10^{-6}$ and $10^{-2}$ parts per volume. The material so deposited included supposedly substitutional phosphorus or boron dopant and was shown to be extrinsic and of n or p conduction type.

While it was not known by these researchers, it is now known by the work of others that the hydrogen in the silane combines at an optimum temperature with many of the dangling bonds of the silicon during the glow discharge deposition, to substantially reduce the density of the localized states in the energy gap toward the end of making the amorphous material electronic properties approximate more nearly the corresponding crystalline material.

The incorporation of hydrogen in the above method not only has limitations based upon the fixed ratio of hydrogen to silicon in silane, but, most importantly, various Si:H bonding configurations introduce new antibonding states which can have deleterious consequences in these materials. Therefore, there are basic limitations in reducing the density of localized states in these materials which are particularly harmful in terms of effective p as well as n doping. The resulting density of states of the silane deposited materials leads to a narrow depletion width, which in turn limits the efficiencies of solar cells and other devices whose operation depends on the drift of free carriers. The method of making these materials by the use of only silicon and hydrogen also results in a high density of surface states which affects all the above parameters. Further, the previous attempts to decrease the band gap of the material while successful in reducing the gap have at the same time added states in the gap. The increase in the states in the band gap results in a decrease or total loss in photoconductivity and is thus counterproductive in producing photoresponsive devices.

After the development of the glow discharge deposition of silicon from silane gas was carried out, work was done on the sputter depositing of amorphous silicon films in the atmosphere of a mixture of argon (required by the sputtering deposition process) and molecular hydrogen, to determine the results of such molecular hydrogen on the characteristics of the deposited amorphous silicon film. This research indicated that the hydrogen acted as an altering agent which bonded in such a way as to reduce the localized states in the energy gap. However, the degree to which the localized states in the energy gap were reduced in the sputter deposition process was much less than that achieved by the silane deposition process described above. The above described p and n dopant gases also were introduced in the sputtering process to produce p and n doped materials. These materials had a lower doping efficiency than the materials produced in the glow discharge process. Neither process produced efficient p-doped materials with sufficiently high acceptor concentrations for producing commerical p-n or p-i-

n junction devices. The n-doping efficiency was below desirable acceptable commercial levels and the p-doping was particularly undesirable since it reduced the width of the band gap and increased the number of localized states in the band gap.

Greatly improved amorphous silicon alloys having significantly reduced concentrations of localized states in the energy gaps thereof and high quality electronic properties have been prepared and deposited by glow discharge as fully described in U.S. Patent No. 4,226,898, Amorphous Semiconductors Equivalent to Crystalline Semiconductors, Stanford R. Ovshinsky and Arun Madan, issued on October 7, 1980, which patent is incorporated herein by reference. As disclosed in this patent, fluorine is introduced into the amorphous semiconductor during the glow discharge deposition to substantially reduce the density of localized states therein. Although the photovoltaic devices described hereinafter may be formed from crystalline, poly-crystalline, or amorphous semiconductor alloy materials, amorphous semiconductor materials are most advantageously employable due to the device efficiencies obtainable with such materials and the low application costs. The glow discharge deposition as disclosed in the aforementioned U.S. Patent No. 4,226,898 ·has process variables directly adaptable to the fabrication of the devices described herein. The devices described herein can also be fabricated by the vapor deposition process and method disclosed in U.S. Patent No. 4,217,374, Amorphous Semiconductors Equivalent to Crystalline Semiconductors, Stanford R. Ovshinsky and Masatsugu Izu, which issued on August 12, 1980. This patent also discloses the introduction of fluorine into an amorphous semiconductor alloy during the vapor deposition thereof to substantially reduce the density of localized states in the band gap to produce an amorphous semiconductor alloy having high quality electronic properties.

The devices previously described, whether formed from crystalline, poly-crystalline, or amorphous semiconductor alloy materials can all benefit from an enhanced open circuit voltage (Voc) without effecting short circuit current (Jsc). Embodiments of the invention provide such enhancement of Voc without effecting Jsc to thereby increase the overall efficiency of these devices. Further, the techniques and methods of the present invention may be employed in virtually any type of photovoltaic device to increase the efficiencies thereof.

The open circuit voltage of prior art photovoltaic devices is enhanced in accordance with one aspect of the present invention by adding enhancement means, suitably an insulating layer, between two semiconductor layers of different conductivity of an active photoresponsive region of a semiconductor body. The semiconductor body may be crystalline, polycrystalline or amorphous semiconductor material. In the case of a crystalline semiconductor body, gallium arsinide (GaAs) may be utilized. In the case of amorphous semiconductor materials, the semiconductor bodies may be formed from a glow discharge or vapor deposition of silane ($SiH_4$) or silicon tetrafluoride ($SiF_4$), the latter being preferred due to the low density of states in the band gaps of such material. Additionally, silicon-germanium or silicon-carbon alloys may also be utilized.

The present invention, in another aspect may be employed in forming electrodes for photoelectrochemical cells by forming an insulating layer over the electrode semiconductor body. The insulating layer is adapted to be in contact with the electrolytic fluid cell to enhance the open circuit voltage and increase the efficiency thereof.

The invention will now be described, by way of example, with reference to the accompanying drawings in which:

Fig. 1 is a fragmentary sectional view of one embodiment of a prior art MIS (metal-insulator-semiconductor) solar cell;

Fig. 2 is a graphical representation of the enhanced Voc obtainable with the MIS device of Fig. 1 as a function of insulator layer width;

Fig. 3 is a graph illustrating the critical width of the insulator layer;

Fig. 4 is a band gap diagram of the MIS device of Fig. 1 under dark and light conditions;

Fig. 5 is a fragmentary sectional view of a prior art p-i-n junction solar cell device;

Fig. 6 is a fragmentary sectional view of an improved Voc enhanced p-i-n solar cell device constructed in accordance with the present invention; and

Fig. 7 is a sectional side view of an improved photoelectrochemical cell having a Voc enhanced electrode constructed in accordance with the present invention.

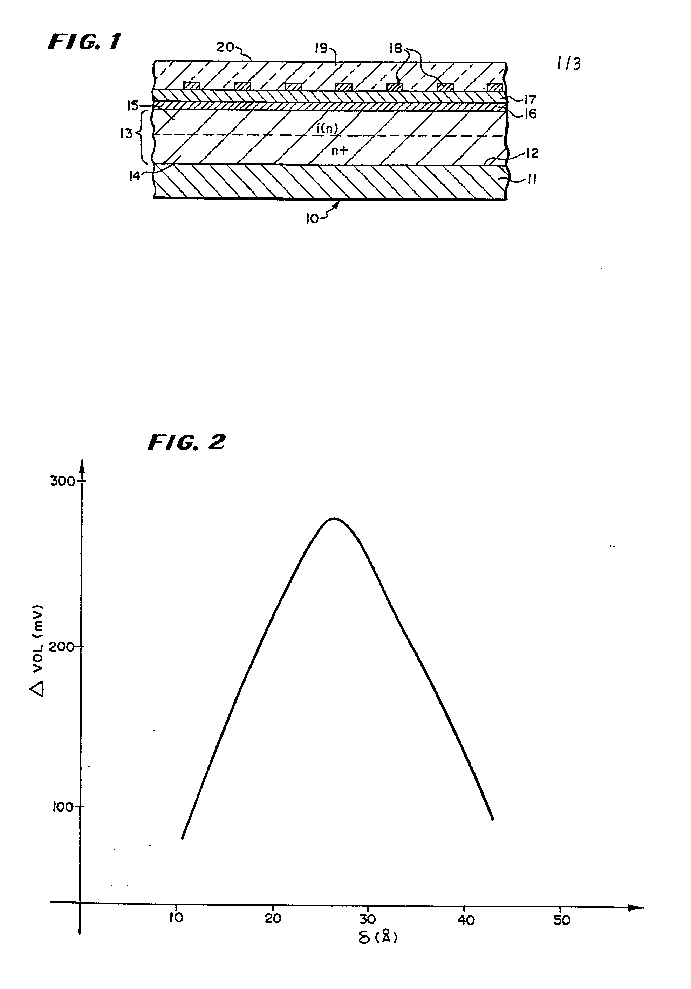

Referring to the drawings, Figure 1 illustrates a prior art metal-insulator-semiconductor (MIS) photovoltaic device 10. The device 10 is formed upon a substrate 11 which may be of any material well known in the prior art having good electrical conductivity. For example, the substrate 11 may be formed from molybdenum having a polished upper surface 12.

A semiconductor body 13 overlies the substrate 12 and includes a n+ region 14 and an active or photoresponsive intrinsic region 15. The semiconductor body 13 may be crystalline, polycrystalline or amorphous semiconductor material. In the case of amorphous semiconductor material, it is preferably deposited onto the substrate 11 in a glow discharge process. The amorphous semiconductor also preferably comprises an amorphous silicon alloy which includes fluorine for decreasing the density of localized states in the band gap thereof.

The n+ region comprises a contact layer for making a good ohmic contact with the substrate 11. It may be formed by introducing n-type dopants into the glow discharge atmosphere during the deposition thereof. Suitable n-type dopants are phosphorus or arsenic.

Overlying the semiconductor body 13 there is formed a thin insulating layer 16. The layer 16 may consist of a stoichiometric oxide compatible with the silicon of the semiconductor body 13 and active region 15. The layer 16 is also formed to have a critical thickness or width $\delta$ as more fully described hereinafter.

The upper surface of the active region 15 joins a metallic region 17, an interface between this metallic region and the amorphous alloy 13 forming a Schottky barrier. The metallic region 17 is transparent or semi-transparent to solar radiation, has good electrical conductivity and is of a high work function (for example, 4.5 eV or greater, produced, for example, by gold, platinum, palladium, etc.) relative to that of the amorphous alloy 13. The metallic region 17 may be a single layer of a metal or it may be a multi-layer. The amorphous alloy 13 may have a thickness of about .5 to 1 micron and the metallic region 17 may have a thickness of about 100 $\overset{\text{O}}{\text{A}}$ in order to be semi-transparent to solar radiation.

On the surface of the metallic region 17 is deposited a grid electrode 18 made of a metal having good electrical conductivity. The grid may comprise orthogonally related lines of conductive material occupying only a minor portion of the area of the metallic region, the rest of which is to be exposed to solar energy. For example, the grid 18 may occupy only about from 5 to 10% of the entire area of the metallic region 17. The grid electrode 18 uniformly collects current from the metallic region 17.

An anti-reflection layer 19 may be applied over the grid electrode 18 and the area of the metallic region 17 between the grid electrode areas. The anti-reflection layer 19 has a solar radiation incident surface 20 upon which impinges the solar radiation. For example, the anti-reflection layer 19 may have a thickness on the order of magnitude of the wavelength of the maximum energy point of the solar radiation spectrum, divided by four times the index of refraction of the anti-reflection layer 19. If the metallic region 17 is platinum of 100 $\overset{\text{o}}{\text{A}}$ in thickness, a suitable anti-reflection layer 19 would be zirconium oxide of about 500 $\overset{\text{o}}{\text{A}}$ in thickness with an index of refraction of 2.1.

Referring now to Fig. 2, it illustrates in graphical form the relation between Voc. enhancement and insulator layer thickness or width. As the width of the insulating layer increases from 10 $\overset{\text{o}}{\text{A}}$ to 30 $\overset{\text{o}}{\text{A}}$, Voc is enhanced or increased from about 75 millivolts to a maximum of 280 millivolts in the resulting MIS photovoltaic device. As the width of the insulating layer is increased further from 30 $\overset{\text{o}}{\text{A}}$ to about 45 $\overset{\text{o}}{\text{A}}$, Voc correspondingly is decreased from the maximum of 280 millivolts to 75 millivolts. Hence, optimized enhancement of Voc is achieved with an insulating layer of about 30 $\overset{\text{o}}{\text{A}}$ in width.

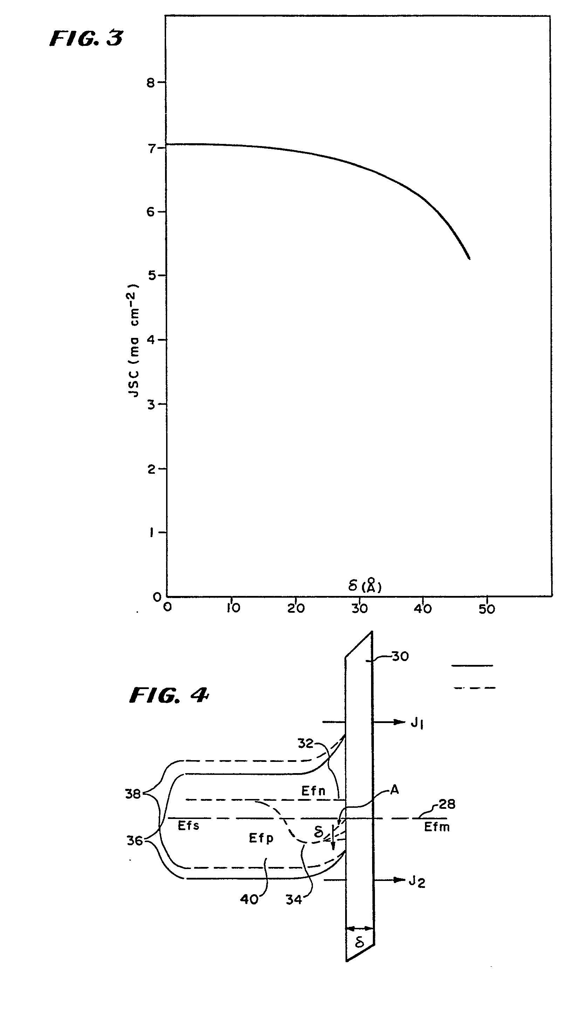

Referring now to Fig. 3, it illustrates the relationship between short circuit current (Jsc) and insulator width. As may be observed, Jsc remains substantially constant or unaffected for insulator widths of 0 $\overset{O}{A}$ (corresponding to a native oxide) to about 30 $\overset{O}{A}$. When the insulator width is increased beyond about 30 $\overset{O}{A}$, Jsc diminishes rapidly. Since an insulator width of about 30 $\overset{O}{A}$ has been found to optimize the enhancement of Voc while virtually not effecting Jsc, maximum device efficiency is obtained with an insulating layer having a thickness or width of about 30 $\overset{O}{A}$.

The enhancement of Voc without affecting Jsc illustrated in Figs. 2 and 3 can best be explained by making reference to Fig. 4. The Fermi level of the metal semiconductor junction under no light (dark conditions) is shown by line 28. Under illumination, the device exhibits what can be referred to as quasi Fermi levels in the semiconductor for the electrons Efn 32 and for the holes Efp 34. The band gap 36 under dark conditions shifts to that illustrated at 38 under light conditions.

An insulator 30 is illustrated joining a semiconductor region 40. Without the insulator 30 (i.e. $\delta=0$), the quasi Fermi level of the holes Efp at the metal semiconductor interface under light conditions lines up with the quasi Fermi level of the metal Efm. In essence, the concentration of the minority carriers (holes) at the metal semiconductor interface is equal to that at the edge of the depletion width, i.e., no impediment to current flow. Next assume an insulator or oxide layer 30 of thickness or width $\delta$. There is a finite probability of the minority carriers tunneling through the insulator 30. Counteracting the tunneling effect would be the increase in minority carrier concentration illustrated by an arrow A which shows an increasing deviation or separation between Efp and Efm as $\delta$ increases. The product of the increasing concentration of holes and decreasing probability of tunneling with increase in insulator thickness or width leads to Jsc shown in Fig. 3.

Now consider that at Voc the minority carrier current $J_2$ must equal the majority current $J_1$. Note that suppression of $J_1$ by increasing $\delta$ without suppressing $J_2$ increases Voc providing the enhancement illustrated in Fig. 2. This obtains because $J_1$ has been decreased and in order to reach the equilibrium condition a higher Voc would be required in order to make $J_1$ equal $J_2$. At some critical insulator width ($\delta$ critical) illustrated in Fig. 3 the tunneling diminishes dramatically and therefore the enhancement of Voc has a maximum as illustrated.

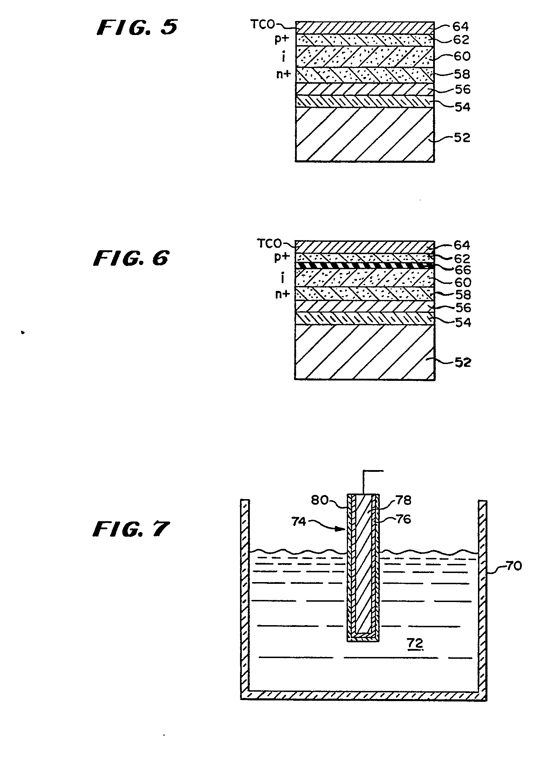

Referring now to Fig. 5, a prior art p-i-n photovoltaic solar cell 50 is illustrated having a substrate 52 which may be glass or a flexible web formed from stainless steel or aluminum. The substrate 52 is of a width and length as desired and preferably at least 3 mils thick. The substrate has an insulating layer 54 deposited thereon by a conventional process. The layer 54 for instance, about 5 microns

thick can be made of a metal oxide. For aluminum substrate, it preferably is aluminum oxide ($Al_2O_3$) and for a stainless steel substrate it may be silicon dioxide ($SiO_2$) or other suitable glass.

An electrode 56 is deposited in one or more layers upon the layer 54 to form a base electrode for the cell 50. The electrode 56 layer or layers is deposited by vapor deposition, which is a relatively fast deposition process. The electrode layers preferably are reflective metal electrodes of molybdenum, aluminum, chrome or stainless steel for a solar cell or a photovoltaic device. The reflective electrode is preferable since, in a solar cell, non-absorbed light which passes through the semiconductor alloy is reflected from the electrode layers 56 where it again passes through the semiconductor alloy which then absorbs more of the light energy to increase the device efficiency.

The substrate 52 is then placed in the deposition environment. The device is formed by first depositing a heavily doped n+ alloy layer 58 on the electrode 56. Once the n+ layer 58 is deposited, an intrinsic (i) alloy layer 60 is deposited thereon. The intrinsic layer 60 is followed by a highly doped conductive p+ alloy layer 62 deposited as the final semiconductor layer. The alloy layers 58, 60 and 62 form the active layers of the p-i-n device 50.

The selected outer, p+ layer 62 is a low light absorption, high conductivity alloy layer. The intrinsic alloy layer 60 has an adjusted wavelength threshold for a solar photoresponse, high light absorption, low dark conductivity and high photoconductivity. The bottom alloy layer 56 is a low light absorption, high conductivity n+ layer. The overall device thickness between the inner surface of the electrode layer 56 and the top surface of the p+ layer 62 is of the order of at least about 3,000 angstroms. The thickness of the intrinsic layer 60 is preferably between about 3,000 angstroms to 30,000 angstroms. The thickness of the top p+ contact layer 62 also is preferably between about 50 to 500 angstroms. Due to the shorter diffusion length of the holes, the p+ layer generally will be as thin as possible on the order of 50 to 150 angstroms. Further the outer layer (here p+ layer 62) whether n+ or p+ will be kept as thin as possible to avoid absorption of light in that contact layer.

Following the deposition of the various semiconductor alloy layers, a further deposition step is performed, preferably in a separate deposition environment. Desirably, a vapor deposition environment is utilized since it is a fast deposition process. In this step, a TCO layer 64 (transparent conductive oxide) is added which, for example, may be indium tin oxide (ITO), cadmium stannate ($Cd_2SnO_4$), or doped tin oxide ($SnO_2$).

An electrode grid can be added to the device if desired. For a device having a sufficiently small area, the TCO layer 64 is generally sufficiently conductive such that a grid is not necessary for good device efficiency. If the device is of a sufficiently large area or if the conductivity of the TCO layer 64 is insufficient, a grid can be placed on the layer 64 to shorten the carrier path and increase the conduction efficiency of the devices.

Now that the principles behind the enhancement in Voc for an MIS device have been explained, this technique may be employed to enhance Voc in virtually any photovoltaic device. For example, Fig. 6 illustrates a p-i-n photovoltaic solar cell substantially indentical to the one illustrated in Fig. 5 except that an insulator layer 66 is disposed between the intrinsic layer 60 and the p+ layer 62. The insulator is formed from silicon nitride $(Si_3N_4)$, silicon dioxide $(SiO_2)$, niobium pentoxide $(Nb_2O_5)$ or tantalum pentoxide $(Ta_2O_5)$ for example. Silicon nitride and silicon dioxide are most preferred because such insulators may be formed witnin the same glow discharge environment in which the other depositions take place. As a result, the semiconductor body including layers 50, 60 and 62 also includes an insulating layer 66 between two semiconductor layers of different conductivity (p+ and intrinsic) to enhance Voc of the device. In addition to relating to semiconductor layers of different conductivity types, the term "different conductivity" is also intended to include or relate to semiconductor layers of the same conductivity type but having different concentrations of dopants. For example, the insulating layer may be disposed between a slightly n-doped conductivity layer and a highly n-doped conductivity layer without departing from the present invention. Alternatively, the insulating layer could be disposed between the n+ layer 56 and the intrinsic layer 60 if the photo generated electron hole pairs are separated at that interface.

The semiconductor body can be formed from crystalline, polycrystalline, or amorphous semiconductor alloys. For example, the crystalline semiconductor may be gallium arsinide (GaAs), silicon, cadmium sulfide or the like. For amorphous semiconductor alloys, the body may be formed from a glow discharge or vapor deposition of silane ($SiH_4$) or silicon tetrafluoride ($SiF_4$). The latter is preferred for amorphous semiconductors because the fluorine within the alloy greatly reduces the density of localized states in the band gaps thereof. Further density of states reducing element(s) such as hydrogen may be incorporated in the alloy as well. Silicon-germainum and silicon-carbon alloys may also be utilized to form the semiconductor body.

As an additional example, the foregoing enhancement technique may be employed in an electrophotochemical electrode as shown in Fig. 7. Here, a cell is illustrated generally including a glass enclosure 70 which contains a quantity of electrolytic fluid 72. Within the fluid 72 there is disposed an electrode 74 constructed in accordance with the present invention. The electrode includes a semiconductor body 76 deposited on a metal substrate 78. The semiconductor body 76 may be formed from any of the various semiconductors previously enumerated. Formed over the semiconductor body 76 is an enhancement layer 80 of insulating material such as glass. The glass (as shown) is adapted to be in contact with the fluid 72 and thus enhances the Voc of the cell.

0051980

- 21 -

<u>CLAIMS</u>

1.    A photovoltaic device, said device comprising superimposed layers of various materials including a semiconductor body having an active photoresponsive region including a band gap therein upon which radiation can impinge to produce charge carriers, said body including at least two semiconductor layers of different conductivity and open circuit voltage enhancement means between said semiconductor layers, said enhancement means comprising means for suppressing majority carrier current flow between said semiconductor layers.

2.    A device as defined in claim 1 wherein said enhancement means comprises a thin insulating layer between said semiconductor layers.

3.    An electrode for a photoelectrochemical cell of the type including an electrolytic fluid, said electrode comprising a semiconductor body having at least one semiconductor layer and an open circuit voltage enhancement means on said layer, said enhancement means being a thin insulating layer adapted to be in contact with said electrolytic fluid to increase the efficiency of said cell.

4.    An article as defined in any preceding claim, wherein said semiconductor body comprises an amorphous semiconductor alloy.

5.       An article as defined in claim 4, wherein said alloy comprises a body of amorphous semiconductor deposited from silane ($SiH_4$).

6.       An article as defined in claim 4, wherein said alloy comprises a body of amorphous semiconductor deposited from silicon tetrafluoride ($SiF_4$).

7.       An article as defined in any one of claims 4 to 6, wherein said amorphous alloy includes at least one density of states reducing element, said element being fluorine.

8.       An article as defined in claim 7, wherein said amorphous alloy further includes a second density of states reducing element, said element being hydrogen.

9.       An article as defined in any preceding claim, wherein said semiconductor body comprises a silicon-germanium alloy.

10.      An article as defined in any one of claims 1 to 4, wherein said semiconductor body comprises a crystalline semiconductor.

11.      An article as defined in claim 10 wherein said crystalline semiconductor comprises gallium arsinide (GaAs) or silicon.

12.      An article as defined in any preceding claim having at least two semiconductor layers, said layers including a p conductivity layer and an n conductivity layer.

13.     An article as defined in any preceding claim, wherein said semiconductor body comprises an inner intrinsic layer and a pair of outer layers on respective opposite sides of said intrinsic layer and being of respective p or n conductivities, and wherein said insulating layer is disposed between said intrinsic layer and one of said outer layers.

14.     A method of making a photovoltaic device comprising the steps of:  depositing at least a first layer of semiconductor material on a substrate; forming an insulating layer over said first layer; and depositing a second layer of semiconductor material over said insulating layer, said second layer being of a different conductivity than said first layer.

15.     A method as defined in claim 14, wherein said layers of semiconductor material are formed from an amorphous semiconductor alloy including at least silicon, and at least one density of states reducing element.

16.     A method as defined in claim 15, wherein said element is fluorine.

17.     A method as defined in claim 16, wherein said alloy further includes a second density of states reducing element, said second element being hydrogen.

**FIG. 1**

**FIG. 2**

**FIG. 3**

**FIG. 4**

**FIG. 5**

TCO — 64
p+ — 62
i — 60
n+ — 58
— 56
— 54
— 52

**FIG. 6**

TCO — 64
p+ — 62
— 66
i — 60
n+ — 58
— 56
— 54
— 52

**FIG. 7**

80 78
74 76
70
72

European Patent Office

**EUROPEAN SEARCH REPORT**

Application number

EP 81 30 5248.7

| | DOCUMENTS CONSIDERED TO BE RELEVANT | | CLASSIFICATION OF THE APPLICATION (Int. Cl. 3) |
|---|---|---|---|
| Category | Citation of document with indication, where appropriate, of relevant passages | Relevant to claim | |
| Y | US - A - 4 200 473 (CARLSON) <br> * claim 1; column 2, lines 11 to 24; column 2, line 65 to column 4, line 3 * <br> -- | 1,2,4, 5,8,12 | H 01 L 31/06 <br> H 01 G 9/20 |
| Y | IEEE TRANSACTIONS ON ELECTRON DEVICES, Vol. ED-27, No. 4, April 1980, New York <br> J. SHEWCHUN et al. "MIS and SIS Solar Cells" <br> pages 705 to 716 <br> * page 705, paragraph 1 to page 706, paragraph 1 * <br> -- | 1,2 | |
| | | | TECHNICAL FIELDS SEARCHED (Int.Cl. 3) |
| Y | DE - A1 - 2 514 013 (LICENTIA PATENT-VERWALTUNGS-GMBH) <br> * page 4; page 5, paragraph 1 * <br> -- | 1,2 | H 01 G 9/20 <br> H 01 L 31/02 <br> H 01 L 31/06 |
| A | GB - A - 2 021 314 (WESTERN ELECTRIC CO. INC.) <br> * page 1, lines 98 to 117; page 2, lines 47 to 85 * <br> -- | 3 | |
| D,A | US - A - 4 217 374 (OVSHINSKY et al.) <br> * claim 1 * <br> ---- | 7,8 | **CATEGORY OF CITED DOCUMENTS** <br> X: particularly relevant if taken alone <br> Y: particularly relevant if combined with another document of the same category <br> A: technological background <br> O: non-written disclosure <br> P: intermediate document <br> T: theory or principle underlying the invention <br> E: earlier patent document, but published on, or after the filing date <br> D: document cited in the application <br> L: document cited for other reasons <br> &: member of the same patent family, corresponding document |

| | The present search report has been drawn up for all claims | | |
|---|---|---|---|
| Place of search <br> Berlin | Date of completion of the search <br> 02-02-1982 | Examiner <br> GIBBS | |

EPO Form 1503.1  06.78